# EUROPEAN PATENT SPECIFICATION

(11) **EP 3 106 884 B1**
(45) Date of publication and mention of the grant of the patent: **19.09.2018**
(21) Application number: 14882186.1
(22) Date of filing: 11.11.2014
(51) Int. Cl.: G01R 15/20

(54) **CURRENT SENSOR**
STROMSENSOR
CAPTEUR DE COURANT

(30) Priority: 13.02.2014 JP 2014025719
(43) Date of publication of application: 21.12.2016
(73) Proprietor: Alps Electric Co., Ltd., Tokyo, 145-8501 (JP)
(72) Inventor: FUKUI, Hirofumi, Tokyo 145-8501 (JP); KANNO, Takeshi, Tokyo 145-8501 (JP); FUJISAKI, Takashi, Tokyo 145-8501 (JP)
(74) Representative: Schmitt-Nilson Schraud Waibel Wohlfrom Patentanwälte Partnerschaft mbB
(86) International application number: PCT/JP2014/079836
(87) International publication number: WO 2015/122064

(56) References cited:
- WO-A1-2011/111459
- WO-A1-2013/128993
- JP-A- 2007 107 972
- US-A1- 2013 257 469

## Description

### Technical Field

The present invention relates to a current sensor for detecting an electric current flowing through a current path to be measured and relates in particular to a current sensor for detecting an electric current flowing through a current path to be measured, by using a magnetoelectric conversion element.

### Background Art

Current sensors which are each attached to a current path to be measured and which each detect an electric current flowing through the current path to be measured, in order to control or monitor various types of electronic equipment, are well known. As current sensors of this type, a current sensor that uses a magnetoelectric conversion element such as a Hall element or a magnetoresistive element is known. In addition, in order to improve sensitivities of magnetoelectric conversion elements, to reduce influences of external magnetizing fields, and so forth, magnetoelectric conversion elements are used in some cases.

In a current sensor utilizing the magnetoelectric conversion elements in this way, in accordance with a direction of a magnetic field generated around a current path to be measured, the magnetoelectric conversion elements are placed on an imaginary circle surrounding the current path to be measured.

However, if the magnetoelectric conversion elements are placed on the imaginary circle as described above, the current sensor grows in size, and in a case where a distance between the current path to be measured and a neighboring current path is small, there is a problem that it is difficult to install the current sensor.

In order to solve such a problem, in a current sensor of PTL 1, magnetoelectric conversion elements are placed on an imaginary ellipse that is centered on a position of a current path to be measured and that has a short axis corresponding a direction connecting the relevant current path to be measured and neighboring current paths to each other. According to the relevant current sensor, it is possible to stably detect an electric current without being greatly influenced by external magnetizing fields of the neighboring current paths and to achieve miniaturization.

### Citation List

### Patent Literature

PTL 1: International Publication No. WO2013/128993

JP 2007 107972 A discloses a current sensor for detecting a current flowing in a current line which is a detection object that has a structure equipped with a semiconductor substrate having seven longitudinal Hall elements. Generated magnetism caused by current flow in the current line disposed vertically to the substrate is detected by the longitudinal Hall elements to thereby detect the current flowing in the current line from the detected magnetism.

US 2013/257469 A1 discloses a current sensor including electromagnetic conversion elements to detect magnetic fields generated when current flows through a current path under test, a chassis that stores the electromagnetic conversion elements and includes a channel to which the current path under test is disposed, and an installation member securable to the chassis. The installation member includes two arm units and a connecting unit to movably connect each end of the two arms.

### Summary of Invention

### Technical Problem

By the way, a current sensor is requested to be installable even in a case where a distance between a current path to be measured and a neighboring current path is even smaller and to be able to stably detect an electric current without being greatly influenced by an external magnetizing field of the neighboring current path.

In view of such a situation, the present invention is made, and an object thereof is to provide a current sensor capable of being further miniaturized and of stably detecting an electric current without being greatly influenced by an external magnetizing field of a neighboring current path.

### Solution to Problem

In order to solve the above-mentioned problem of the related art and to achieve the above-mentioned object, current sensors according to the invention are defined in the independent claims 1, 4 and 5.

A current sensor of the present invention includes a wiring substrate, and magnetoelectric conversion elements provided in the wiring substrate and configured to detect magnetism generated by an electric current flowing through a current path to be measured, wherein a cutout for positioning the current path to be measured in a center of an imaginary rectangle is formed in the wiring substrate, the magnetoelectric conversion elements are provided on 4 corners and long sides of the rectangle so as to be line-symmetrical with respect to a first imaginary line being parallel to the long sides of the rectangle and passing through a center of the rectangle and to be point-symmetrical with respect to the center, each of magnetoelectric conversion elements on the long sides is placed within a range of an angle of 45° from a second imaginary line in a clockwise or counterclockwise direction about the center, the second imaginary line being orthogonal to the first imaginary line and passing through the center, directions of sensitivity axes of the magnetoelectric conversion elements placed on the long sides are parallel to the long sides, directions of sensitivity axes of the magnetoelectric conversion elements placed on the corners are parallel to short sides, and directions of sensitivity axes of the magnetoelectric conversion elements located at point-symmetrical positions centered on the center are equal or opposite to each other.

According to the above-mentioned configuration, by placing magnetoelectric conversion elements as described above, in a direction in which the second imaginary line extends, it is possible to reduce an area in which the magnetoelectric conversion elements are placed, and it is possible to reduce distances from current paths (neighboring current paths) adjacent to the current path to be measured. From this, it is possible to achieve miniaturization of a wiring substrate 16, in other words, miniaturization of a current sensor 101.

In addition, it is possible to relatively reduce the influences of external magnetizing fields from the neighboring current paths. Accordingly, since the influences of the external magnetizing fields on the magnetoelectric conversion elements are reduced, it is possible to stably obtain detection values from the magnetoelectric conversion elements.

In addition, as described above, by specifying the directions of the sensitivity axes of the magnetoelectric conversion elements in parallel to the long sides and short sides of the imaginary rectangle, compared with a case where magnetoelectric conversion elements are placed on the circumference of circle at regular intervals, it is possible to easily mount in a case of mounting the individual magnetoelectric conversion elements in the wiring substrate 16, and it is possible to easily design a positional relationship between the wiring substrate and the magnetoelectric conversion elements. Accordingly, since it is possible to enhance the accuracy of a mounting angle, a mounting position, or the like of the current path to be measured, it is possible to improve measurement accuracy.

In addition, according to the above-mentioned configuration, the directions of magnetic fields applied to the individual magnetoelectric conversion elements and magnetism sensing directions are less than 45 degrees, and it is possible to maintain favorable sensitivities.

In addition, according to the above-mentioned configuration, it is only necessary to adjust the positions of the magnetoelectric conversion elements in the directions of the long sides and short side of the rectangle. Therefore, design for improving measurement accuracy becomes easy.

It is preferable that the magnetoelectric conversion elements on the long sides of the current sensor of the present invention are placed line-symmetrically with respect to the second imaginary line.

According to the above-mentioned configuration, position adjustment is easy, and design for improving measurement accuracy becomes easy.

It is preferable that, in the current sensor of the present invention, magnetoelectric conversion elements are placed at 2 positions at which the long sides and the second imaginary line intersect with each other, and magnetoelectric conversion elements, included in the magnetoelectric conversion elements on the long sides and different from the magnetoelectric conversion elements placed at the positions at which the long sides and the second imaginary line intersect with each other, are placed line-symmetrically with respect to the second imaginary line.

According to the above-mentioned configuration, position adjustment is easy, and design for improving measurement accuracy becomes easy. In addition, according to the above-mentioned configuration, it is possible to arrange many magnetoelectric conversion elements in an area in which a magnetic field from the current path to be measured is strong and the direction component of the magnetic field along the first imaginary line is large, and it is possible to relatively reduce the influences of external magnetizing fields from the neighboring current paths placed at adjacent positions. Accordingly, since the influences of the external magnetizing fields on the magnetoelectric conversion elements are reduced, it is possible to stably obtain detection values from the magnetoelectric conversion elements.

It is preferable that the current sensor of the present invention includes 4 magnetoelectric conversion elements placed in the 4 corners, 2 magnetoelectric conversion elements configured to be located on the second imaginary line, to be arranged outside the rectangle, and to be line-symmetrical with respect to the first imaginary line, and 4 magnetoelectric conversion elements placed at positions on the long sides, at which the second imaginary line does not intersect.

According to the above-mentioned configuration, by placing the magnetoelectric conversion elements outside the imaginary rectangle, it is possible to reduce the sensitivities of the magnetoelectric conversion elements having the highest sensitivity and to perform highly accurate detection with a wide dynamic range. In addition, it is possible to reduce broadening of the width of the arrangement area of the magnetoelectric conversion elements.

It is preferable that the current sensor of the present invention includes 4 magnetoelectric conversion elements placed in the 4 corners, 4 magnetoelectric conversion elements located on the long sides, and 4 magnetoelectric conversion elements configured to be located nearer to the second imaginary line than the 4 magnetoelectric conversion elements on the long sides, to be arranged outside the rectangle, and to be line-symmetrical with respect to the first imaginary line.

According to the above-mentioned configuration, by placing the magnetoelectric conversion elements outside the imaginary rectangle, it is possible to reduce the sensitivities of the magnetoelectric conversion elements having the highest sensitivity and to perform highly accurate detection with a wide dynamic range. In addition, it is possible to reduce broadening of the width of the arrangement area of the magnetoelectric conversion elements.

It is preferable that the magnetoelectric conversion elements of the current sensor of the present invention have an identical characteristic.

It is preferable that, in the current sensor of the present invention, the magnetoelectric conversion elements are placed so that the sensitivity axes of the magnetoelectric conversion elements face in one direction along the rectangle.

According to the above-mentioned configuration, design for improving measurement accuracy becomes easy.

### Advantageous Effects of Invention

According to the present invention, it is possible to provide a current sensor capable of being further miniaturized and of stably detecting an electric current without being greatly influenced by an external magnetizing field of a neighboring current path.

### Brief Description of Drawings

[Fig. 1] Fig. 1 is an exploded perspective view illustrating a current sensor according to a first embodiment of the present invention.
[Fig. 2] Fig. 2 is a perspective view illustrating the current sensor according to the first embodiment of the present invention.
[Fig. 3] Fig. 3 is a diagram for explaining the current sensor according to the first embodiment of the present invention and is a top view of a wiring substrate viewed from a Z1 side illustrated in Fig. 1.
[Fig. 4] Fig. 4 is an exploded perspective view illustrating a current sensor according to a second embodiment of the present invention.
[Fig. 5] Fig. 5 is a diagram for explaining the current sensor according to the second embodiment of the present invention and is a top view of a wiring substrate viewed from the Z1 side illustrated in Fig. 1.
[Fig. 6] Fig. 6 is a top view of a wiring substrate of a current sensor according to a third embodiment of the present invention.
[Fig. 7] Fig. 7 is a top view of a wiring substrate of a current sensor according to a fourth embodiment of the present invention.
[Fig. 8] Fig. 8 is a diagram for comparing distances between a current path CB to be measured and neighboring current paths CN and the degree of influence of the neighboring current paths on detection values, regarding the current sensor of the second embodiment of the present invention and a comparative example (ellipse) in which 10 magnetoelectric conversion elements are arranged on an imaginary ellipse.

### Description of Embodiments

### <First Embodiment>

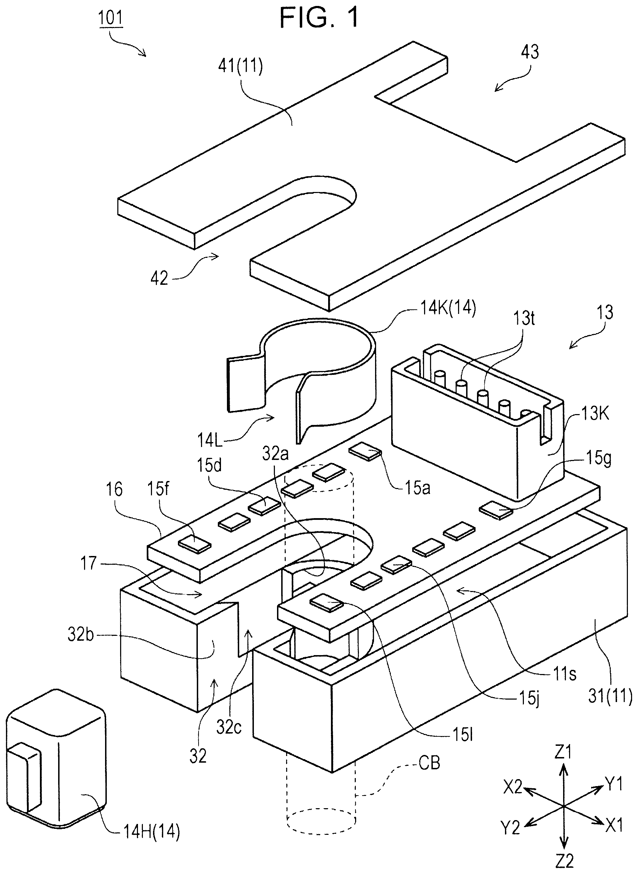

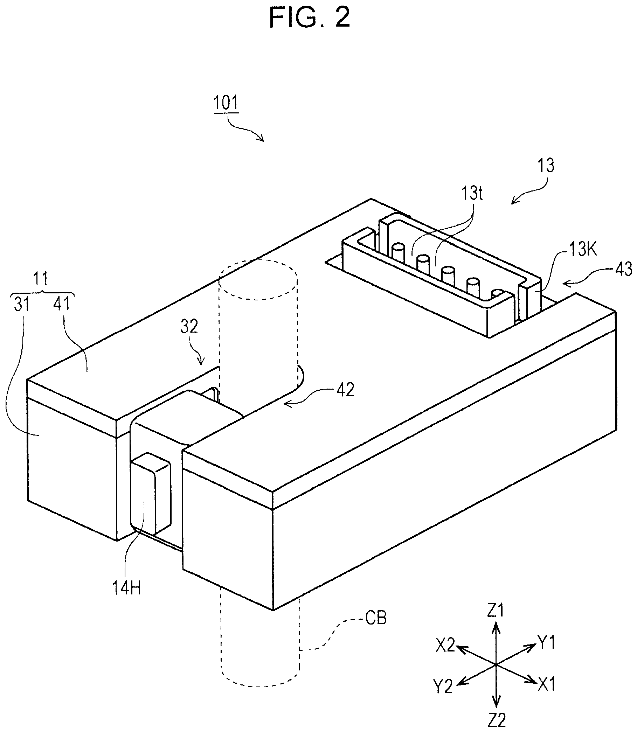

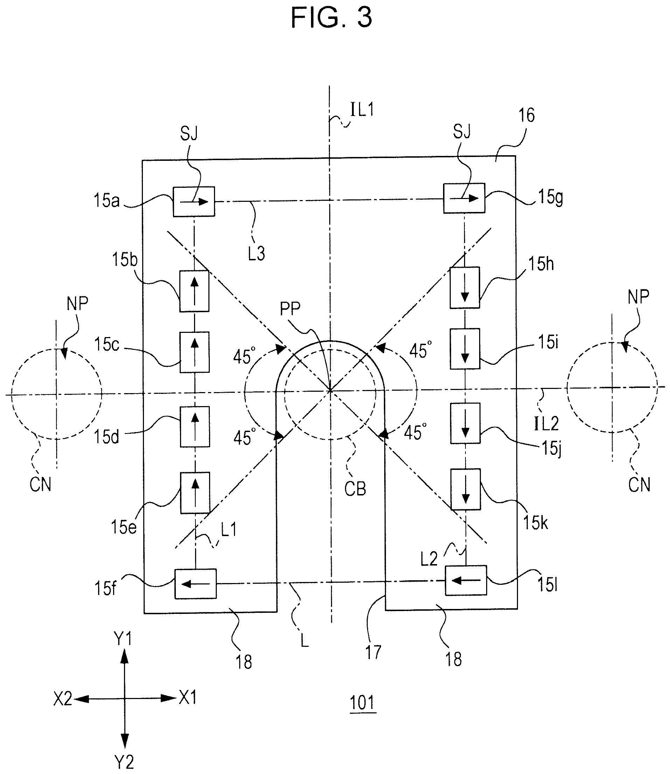

Fig. 1 is an exploded perspective view illustrating the current sensor 101 according to a first embodiment of the present invention. Fig. 2 is a perspective view illustrating the current sensor 101 according to the first embodiment of the present invention. Fig. 3 is a diagram for explaining the current sensor 101 according to the first embodiment of the present invention and is a top view of the wiring substrate 16 viewed from a Z1 side illustrated in Fig. 1.

As illustrated in Fig. 1 and Fig. 2, the current sensor 101 according to the first embodiment of the present invention is configured to include magnetoelectric conversion elements 15 that each detect magnetism generated upon an electric current flowing through the current path CB to be measured, and the wiring substrate 16 in which the magnetoelectric conversion elements 15 are arranged. In addition, the current sensor 101 includes a chassis 11 including a housing portion 11s for housing the wiring substrate 16, a connector 13 including extraction terminals 13t for extracting electric signals from the magnetoelectric conversion elements 15, and a holding member 14 for fixing and holding the current path CB to be measured.

The chassis 11 is formed of a synthetic resin material such as, for example, ABS (acrylonitrile butadiene styrene) or PET (polyethylene terephthalate). This chassis 11 includes a box-shaped case 31 with the top thereof opened and a plate-like cover 41 shaped so as to close the opening portion of the case 31, and the housing portion 11s for housing the wiring substrate 16 is formed within the case 31. Note that the material of which the chassis 11 is formed is not restricted to a synthetic resin material, and a configuration using, for example, a metal material may be employed if the metal material is not a ferromagnetic substance.

The case 31 has a concave portion (concave groove) 32 formed in a manner of cutting out from one side thereof toward a center side of the case 31 and is configured so that the current path CB to be measured is introduced into the concave portion 32 and held there. A far wall 32a of the concave portion 32 is formed so as to have a mutually complementary shape with the outer peripheral surface of the current path CB to be measured. In the present embodiment, the far wall 32a of the concave portion 32 is formed in a shape curved in an arc so as to correspond to the outer peripheral surface of the cylindrically shaped current path CB to be measured. In addition, in inner walls 32b of the case 31, which face each other and which are continuous with the far wall 32a, cutouts 32c that catch together the free end portions of a clip spring 14K are formed at positions facing each other. The cutouts 32c are cut out downward from upper end portion sides of the respective inner walls 32b and are formed so that end surfaces on respective inlet sides are inclined outward. In a state in which the far side of the outer peripheral surface of the current path CB to be measured is brought into contact with the far wall 32a of the concave portion 32, the near side thereof is sandwiched by the clip spring 14K that protrudes from the cutouts 32c into the concave portion 32, and accordingly, the current path CB to be measured is held with respect to the chassis 11. A position at which the current path CB to be measured is sandwiched between the far wall 32a of the concave portion 32 and the clip spring 14K is a placement position PP of the current path CB to be measured with respect to the chassis 11. In the present embodiment, the placement position PP is a center PP of an imaginary rectangle L described later.

The cover 41 has an opening portion 42, which has the same shape as that of the concave portion 32 of the case 31 and which is formed in one of side portions so as to correspond thereto, and has an opening portion 43 to expose the upper end portion of the connector 13 to the outside of the chassis 11, the opening portion 43 being formed in a side portion opposite to the side portion where the opening portion 42 is formed.

The holding member 14 is a member for fixing and holding the current path CB to be measured and includes the clip spring 14K to sandwich and hold the outer periphery of the current path CB to be measured, and a pressing member 14H to press the clip spring 14K after the current path CB to be measured is placed at the placement position PP.

A strip-shaped leaf spring is bent into a roughly circular shape when viewed in plan, and two free end portions are bent in a direction (outward) of being separated from each other so as to form a gap 14L on a free end portion side, thereby forming the clip spring 14K. This clip spring 14K is housed within the housing portion 11s of the case 31 and is placed so that in a state where a curved portion is caused to follow the far wall 32a of the concave portion 32, the free end portions are brought into contact with the inclined surfaces of the cutouts 32c and bent portions on the free end portion side protrude from the cutouts 32c into the concave portion 32. Here, the gap 14L between the bent portions on the free end portion side of the clip spring 14K is formed so as to be narrower than the maximum diameter (maximum width) dimension of the current path CB to be measured introduced into the concave portion 32, in order to permit the current path CB to be measured to be introduced to the placement position PP and also to prevent the current path CB to be measured from easily falling off from the placement position PP.

The pressing member 14H is formed in a roughly rectangular parallelepiped shape and is manufactured to a size able to be firmly fit into the concave portion 32 formed in the case 31. This pressing member 14H is held within the concave portion 32 of the case 31 in a state of pressing the clip spring 14K. In the current sensor 101 formed in this way, upon the current path CB to be measured being introduced into the concave portion 32 of the case 31 and being pressed against the bent portions of the clip spring 14K exposed into the concave portion 32, the clip spring 14K allows deflection such that the bent portions evacuate into the housing portion 11s while the free end portions are guided along the inclined surfaces of the cutouts 32c, and the spacing 14L between the bend portions spreads. Upon the current path CB to be measured being farther pressed until making contact with the far wall 32a, the bent portions return to the initial positions exposed within the concave portion 32 while the free end portions are guided along the inclined surfaces of the cutouts 32c. At this time, the outer peripheral surface of the current path CB to be measured is sandwiched by the far wall 32a and the bend portions of the clip spring 14K. If the pressing member 14H is pressed into the concave portion 32, the clip spring 14K (the bent portions thereof) is pressed down. The holding member 14 including the pressing member 14H and clip spring 14K cooperates with the far wall 32a of the concave portion 32, thereby enabling the current path CB to be measured to be precisely placed at the placement position PP. Note that while the cross-sectional shape of the current path CB to be measured is circular in the present embodiment, a current path to be measured whose cross-sectional shape is rectangular may be used instead. In this case, the shape of the clip spring 14K of the holding member 14 preferably corresponds to the rectangular cross-sectional shape of the current path to be measured.

For example, a generally well known two-sided printed circuit board (PCB) is used for the wiring substrate 16, and a metal foil such as copper (Cu) or the like, provided on a base substrate formed of an epoxy resin including glass, is patterned, thereby forming a wiring pattern. The wiring substrate 16 is formed in a size able to be housed in the housing portion 11s of the case 31, and a cutout 17 into which the current path CB to be measured is inserted and placed is formed in one side portion of the wiring substrate 16. In other words, the wiring substrate 16 is formed in a shape similar to the bottom surface portion of the housing portion 11s, and the cutout 17 having a mutually complementary shape with the concave portion 32 of the case 31 is formed. As illustrated in Fig. 1 to Fig. 3, the magnetoelectric conversion elements 15 (the number thereof is 12) are arranged near the cutout 17 of the wiring substrate 16, and the connector 13 is placed near a side portion of the wiring substrate 16, opposite to the side portion where the cutout 17 is formed. Note that a detailed arrangement position of the magnetoelectric conversion elements 15 will be described later. In addition, while, in the present embodiment, a printed circuit board (PCB) formed of an epoxy resin including glass is used for the wiring board 16, this is not restrictive, any insulating rigid substrate may be used, and, for example, a ceramic wiring board may be used. In addition, while a two-sided printed circuit board (PCB) is used as the wiring substrate 16 in the present embodiment, a single-sided printed circuit board (PCB) may be used depending on a result of circuit design.

The connector 13 has terminals to electrically connect to a counterpart connector (illustration thereof is omitted), and the terminals include the extraction terminals 13t for extracting the electrical signals from the magnetoelectric conversion elements 15. In addition, the connector 13 includes an insulating base 13K for fitting into the partner connector (illustration thereof is omitted). The insulating base 13K is formed in a box shape with the top thereof open, and inside thereof, terminals including the extraction terminals 13t are housed in a state where the terminals are insulated from one another. Note that while the connector 13 is used in the present embodiment in order to extract electric signals from the magnetoelectric conversion elements 15, the connector 13 is not restrictive, and, for example, a flexible printed circuit board (FPC: Flexible Printed Circuits) or the like may be used.

The magnetoelectric conversion elements 15 are current sensor elements, which detect magnetism generated in a case where a current flows through the current path CB to be measured, and magnetic detecting elements utilizing, for example, the giant magnetoresistive effect (called giant magneto resistive (GMR) elements) may be used. While detailed illustration is omitted for ease of explanation, a diced chip is packaged by a thermosetting synthetic resin after GMR elements are manufactured on a silicon substrate, and lead terminals for signal extraction are electrically connected to the GMR elements, thereby forming the magnetoelectric conversion elements 15. In addition, the wiring substrate 16 is subjected to soldering, by using the lead terminals.

As illustrated in Fig. 3, in the current sensor 101, 12 magnetoelectric conversion elements 15a to 151 are placed on the imaginary rectangle L having the center PP.

Note that that the magnetoelectric conversion elements 15a to 151 are located on the rectangle L or the like in the present embodiment means that the center points of the magnetoelectric conversion element 15 are located on long sides, short sides, or corners of the rough rectangle L or the like.

The magnetoelectric conversion elements 15a to 151 have, for example, an identical magnetoelectric conversion characteristic. From this, design for improving the measurement accuracy of the current sensor 101 becomes easy.

As described above, the center PP of the rectangle L is a center of a transverse section (X-Y cross-section) of the current path CB to be measured. The cutout 17 has such a shape that it is possible to position the center of the current path CB to be measured in the center PP of the imaginary rectangle L in a case where the current sensor 101 is positioned with respect to the current path CB to be measured.

As illustrated in Fig. 3, on a surface of the wiring substrate 16 on a left side (X2 direction side) of the cutout 17 when viewed from a Y1 direction, the magnetoelectric conversion elements 15a to 15f are placed. In addition, on a surface of the wiring substrate 16 on a right side (X1 direction side) of the cutout 17 when viewed from the Y1 direction, the magnetoelectric conversion elements 15g to 151 are placed.

Here, the magnetoelectric conversion elements 15a, 15f, 15g, and 151 are placed in 4 corners of the rectangle L.

In addition, the magnetoelectric conversion elements 15b, 15c, 15d, and 15e are placed on an imaginary long side L1 of the rectangle L, and the magnetoelectric conversion elements 15g, 15h, 15i, 15j, and 15k are placed on an imaginary long side L2 of the rectangle L.

The magnetoelectric conversion elements 15g, 15h, 15i, 15j, and 15k are placed line-symmetrically with the magnetoelectric conversion elements 15b, 15c, 15d, and 15e, respectively, with respect to a first imaginary line IL1 that is parallel to the long sides L1 and L2 and that passes through the center PP.

The magnetoelectric conversion elements 15g, 15h, 15i, 15j, and 15k are placed point-symmetrically with the magnetoelectric conversion elements 15f, 15e, 15d, 15c, 15b, and 15a, respectively, with respect to the center PP of the rectangle L.

As a result, the magnetoelectric conversion elements 15a, 15b, 15c, 15g, 15h, and 15i are placed line-symmetrically with the magnetoelectric conversion element 15f, 15e, 15d, 151, 15k, and 15j, respectively, with respect to a second imaginary line IL2 that is orthogonal to the first imaginary line IL1 and that passes through the center PP.

By placing the magnetoelectric conversion elements 15a to 151 in this way, compared with a case (comparative example) where magnetoelectric conversion elements are placed on the circumference of circle at regular intervals, it is possible to reduce a placement space of the magnetoelectric conversion elements 15a to 151 even in a case of the arrangement of the magnetoelectric conversion elements 15a to 151 in which the current path CB to be measured is inserted and placed. In other words, in a case of the magnetoelectric conversion elements according to the comparative example, the magnetoelectric conversion element are evenly arranged at regular intervals in a circumferential direction centered on the placement position of the current path CB to be measured. Therefore, in a case where the current path CB to be measured is introduced between the magnetoelectric conversion elements and is placed at the placement position, it is necessary to secure a spacing through which at least the current path CB to be measured is able to pass, as element spacings between the magnetoelectric conversion elements. Therefore, the placement area of all the magnetoelectric conversion elements becomes large, and as a result, a wiring substrate grows in size.

On the other hand, in a case of the arrangement of the magnetoelectric conversion elements 15 according to the present embodiment, the 6 magnetoelectric conversion elements 15a to 15f are placed on the long side L1 of the rectangle L, and the 6 magnetoelectric conversion elements 15g to 151 are placed on the long side L2 of the rectangle L.

Therefore, it is possible to reduce a distance in a short side L3 direction (X direction) necessary to arrange the magnetoelectric conversion elements 15a to 15f and the magnetoelectric conversion elements 15g to 151. In other words, it is possible to reduce distances between the current path CB to be measured and the adjacent current paths CN.

As a result, compared with the placement area of magnetoelectric conversion elements C35 according to a comparative example 3, it is possible to reduce the placement area of the magnetoelectric conversion elements 15 in a direction (an extending direction of the second imaginary line IL2) orthogonal in particular to a formation direction of the cutout 17, and it is possible to achieve miniaturization of the wiring substrate 16, in other words, miniaturization of the current sensor 101. In particular, for purpose of providing current paths at as short intervals as possible in such a manner as a distribution board, it becomes important to be able to reduce the widths of right and left arm portions 18 of the cutout 17.

In addition, each of the magnetoelectric conversion elements 15b, 15c, 15d, and 15e on the long side L1 of the rectangle L is placed within a range of an angle of 45° from the X2 direction of the second imaginary line IL2 in a clockwise or counterclockwise direction about the center PP.

In addition, each of the magnetoelectric conversion elements 15h, 15i, 15j, and 15k on the long side L2 is placed within a range of an angle of 45° from an X1 direction of the second imaginary line IL2 in a clockwise or counterclockwise direction about the center PP.

In this way, element spacings between the magnetoelectric conversion elements 15a to 15f and the magnetoelectric conversion elements 15g to 151 are not made equal in the long-side direction of the rectangle L, but are each concentrated within a range of an angle of 45° from the X1 or X2 direction of the second imaginary line IL2 in a clockwise or counterclockwise direction about the center PP. Accordingly, it is possible to arrange many magnetoelectric conversion elements in an area in which the magnetic field of the current path CB to be measured is strong and the Y direction component of the magnetic field is large, and it is possible to relatively reduce the influences of external magnetizing fields from the neighboring current paths CN placed at adjacent positions. Accordingly, since the influences of the external magnetizing fields on the magnetoelectric conversion elements 15 are reduced, it is possible to stably obtain detection values from the magnetoelectric conversion elements 15.

The direction SJ of a sensitivity axis (a direction in which magnetism is sensed) of each of the magnetoelectric conversion elements 15a to 151 is parallel to the long side L1, long side L2, or short side L3 of the rectangle L and is one direction along the rectangle L. From this, design for improving the measurement accuracy of the current sensor 101 becomes easy.

Specifically, the directions SJ of the sensitivity axes of the magnetoelectric conversion elements 15a and 15g placed in corners of the rectangle L correspond to the X1 direction, and the directions SJ of the sensitivity axes of the magnetoelectric conversion elements 15f and 151 correspond to the X2 direction.

In addition, the directions SJ of the sensitivity axes of the magnetoelectric conversion elements 15b, 15c, 15d, and 15e correspond to the Y1 direction, and the directions SJ of the sensitivity axes of the magnetoelectric conversion elements 15h, 15i, 15j, and 15k correspond to a Y2 direction.

From this, the directions SJ of the sensitivity axes of the magnetoelectric conversion elements 15a to 151 are opposite to those of the magnetoelectric conversion element 151 to 15a, respectively, located at point-symmetrical positions centered on the center PP.

In an arithmetic circuit located at a subsequent stage, by adding the outputs of the magnetoelectric conversion elements 15a to 151, components corresponding to the magnetic field of the current path CB to be measured are accumulated and validated, and components corresponding to the magnetic fields of the adjacent current paths CN are cancelled out.

Note that in the example of Fig. 3, the direction SJ of the sensitivity axis of the magnetoelectric conversion element 15g may be set to the X2 direction opposite to that of the magnetoelectric conversion element 15a, the direction SJ of the sensitivity axis of the magnetoelectric conversion element 151 may be set to the X1 direction opposite to that of the magnetoelectric conversion element 15f, and the directions SJ of the sensitivity axes of the magnetoelectric conversion elements 15h, 15i, 15j, and 15k may be set to the Y1 direction equal to those of the magnetoelectric conversion elements 15b, 15c, 15d, and 15e.

In this case, in the arithmetic circuit located at a subsequent stage, by subtracting the outputs of the magnetoelectric conversion elements 15g to 151 from the outputs of the magnetoelectric conversion elements 15a to 15f, components corresponding to the magnetic field of the current path CB to be measured are accumulated and validated, and components corresponding to the magnetic fields of the adjacent current paths CN are cancelled out.

As described above, according to the current sensor 101, by arranging the magnetoelectric conversion elements 15a to 151 as illustrated in Fig. 3, it is possible to minimize the width of the arrangement area of the magnetoelectric conversion elements 15a to 151 in the X direction and to reduce distances between the current path CB to be measured and the adjacent current paths CN. From this, it is possible to achieve miniaturization of the wiring substrate 16, in other words, miniaturization of the current sensor 101. In particular, it is possible to reduce the widths of the right and left arm portions 18 of the cutout 17.

In addition, according to the current sensor 101, by arranging the magnetoelectric conversion elements 15a to 151 as illustrated in Fig. 3, it is possible to relatively reduce the influences of external magnetizing fields from the neighboring current paths CN placed at adjacent positions. Accordingly, since the influences of the external magnetizing fields on the magnetoelectric conversion elements 15a to 151 are reduced, it is possible to stably obtain detection values from the magnetoelectric conversion elements 15a to 151. By using simulation, it is confirmed that it is possible to remove the influence of adjacent electric wires in this way.

In addition, according to the current sensor 101, by specifying the directions SJ of the sensitivity axes of the magnetoelectric conversion elements 15a to 151 as illustrated in Fig. 3, compared with a case (comparative example) where the magnetoelectric conversion elements C35 are placed on the circumference of circle at regular intervals, it is possible to easily mount in a case of mounting the individual magnetoelectric conversion elements 15a to 151 in the wiring substrate 16, and it is possible to easily design a positional relationship between the wiring substrate 16 and the magnetoelectric conversion elements 15a to 151. Accordingly, since it is possible to enhance the accuracy of a mounting angle, a mounting position, or the like of the current path CB to be measured, it is possible to improve measurement accuracy.

In the current sensor 101, the directions of magnetic fields applied to the individual magnetoelectric conversion elements 15a to 151 and magnetism sensing directions are less than 45 degrees, and it is possible to maintain favorable sensitivities.

In the current sensor 101, in a case where an electric current flowing through the current path CB to be measured and electric currents flowing through the adjacent current paths CN are equal in direction, the magnetoelectric conversion elements 15a, 15f, 15g, and 151 in the corners of the rectangle L and the magnetoelectric conversion element 15b, 15c, 15d, 15e, 15h, 15i, 15j, and 15k on the long sides L1 and L2 located on sides far from the adjacent current paths CN have (+) side errors. On the other hand, the magnetoelectric conversion elements on the long sides L1 and L2 located on sides near to the adjacent current paths CN have (-) side errors. Since there are the (+) side errors and the (-) side errors, it is possible to cancel out the errors.

Since the 12 magnetoelectric conversion elements 15a to 151 are used in the current sensor 101, it is possible to arrange the magnetoelectric conversion elements on the straight lines that form 2 rows and that are located on 2 sides of the cutout 17, and it is only necessary to adjust positions in the directions of the long sides L1 and L2 and short side L3 of the rectangle L. Therefore, design for improving measurement accuracy becomes easy.

### <Second Embodiment>

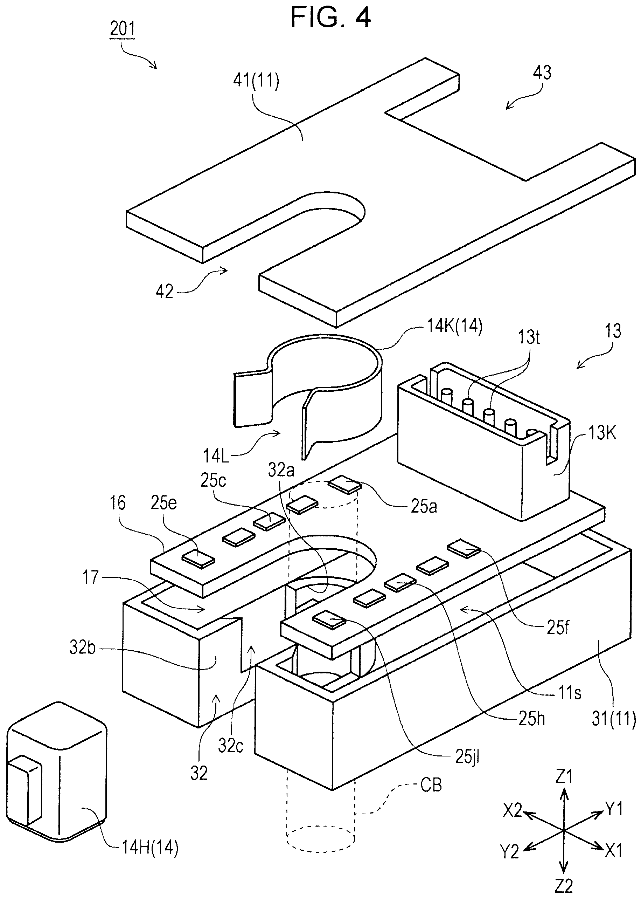

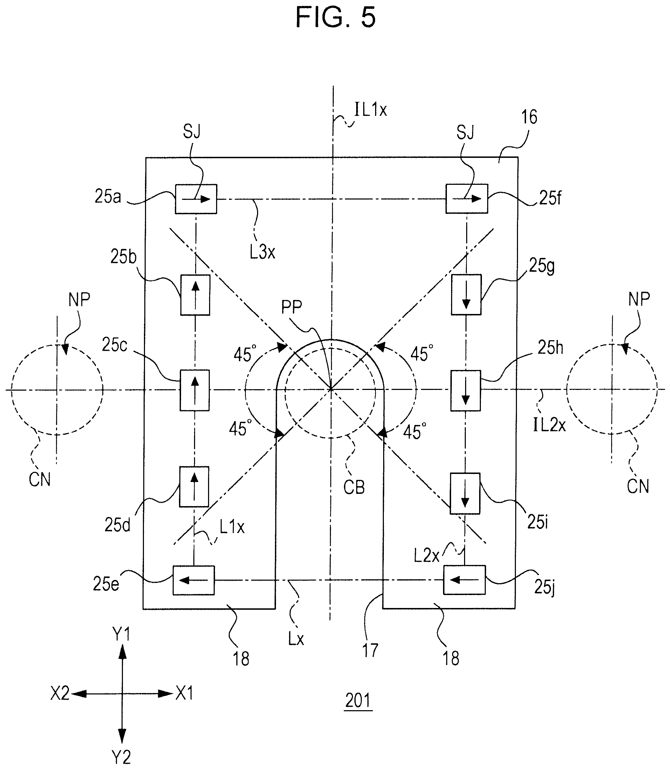

Fig. 4 is an exploded perspective view illustrating a current sensor 201 according to a second embodiment of the present invention. Fig. 5 is a diagram for explaining the current sensor 201 according to the second embodiment of the present invention and is a top view of the wiring substrate 16 viewed from the Z1 side illustrated in Fig. 4.

As illustrated in Fig. 4 and Fig. 5, magnetoelectric conversion elements 25a to 25j (the number thereof is 10) are arranged near the cutout 17 of the wiring substrate 16.

As illustrated in Fig. 5, in the current sensor 201, the 10 magnetoelectric conversion elements 25a to 25j are placed on an imaginary rectangle Lx having the center PP. The center PP is the center of the transverse section (X-Y cross-section) of the current path CB to be measured. The cutout 17 has such a shape that it is possible to position the center of the current path CB to be measured in the center of the imaginary rectangle Lx in a case where the current sensor 201 is positioned with respect to the current path CB to be measured.

As illustrated in Fig. 5, on the surface of the wiring substrate 16 on the left side (X2 direction side) of the cutout 17 when viewed from the Y1 direction, the magnetoelectric conversion elements 25a to 25e are placed. In addition, on the surface of the wiring substrate 16 on the right side (X1 direction side) of the cutout 17 when viewed from the Y1 direction, the magnetoelectric conversion elements 25f to 25j are placed.

Here, the magnetoelectric conversion elements 25a, 25e, 25f, and 25j are placed in 4 corners of the rectangle L.

In addition, the magnetoelectric conversion elements 25b, 25c, and 25d are placed on an imaginary long side L1x of the rectangle Lx, and the magnetoelectric conversion elements 25g, 25h, and 25i are placed on an imaginary long side L2x of the rectangle Lx.

The magnetoelectric conversion elements 25c and 25h are placed on a second imaginary line IL2x that is orthogonal to a first imaginary line IL1x and that passes through the center PP.

The magnetoelectric conversion elements 25f, 25g, 25h, 25i, and 25j are placed line-symmetrically with the magnetoelectric conversion elements 25a, 25b, 25c, 25d, and 25e, respectively, with respect to the first imaginary line IL1x that is parallel to the long sides L1x and L2x and that passes through the center PP.

The magnetoelectric conversion elements 25f, 25g, 25h, 2i, and 25j are placed point-symmetrically with the magnetoelectric conversion elements 25e, 25d, 25c, 25b, and 25a, respectively, with respect to the center PP of the rectangle Lx.

As a result, the magnetoelectric conversion elements 25a, 25b, 25f, and 25g are placed line-symmetrically with the magnetoelectric conversion element 25e, 25d, 25j, and 25i, respectively, with respect to the second imaginary line IL2x.

By placing the magnetoelectric conversion elements 25a to 25j in this way, compared with a case (comparative example) where the magnetoelectric conversion elements are placed on the circumference of circle at regular intervals, it is possible to reduce a placement space of the magnetoelectric conversion elements 25a to 25j even in a case of the arrangement of the magnetoelectric conversion elements 25a to 25j in which the current path CB to be measured is inserted and placed. In other words, in a case of the magnetoelectric conversion elements according to the comparative example, the magnetoelectric conversion element are evenly arranged at regular intervals in a circumferential direction centered on the placement position of the current path CB to be measured. Therefore, in a case where the current path CB to be measured is introduced between the magnetoelectric conversion elements and is placed at the placement position, it is necessary to secure a spacing through which at least the current path CB to be measured is able to pass, as element spacings between the magnetoelectric conversion elements. Therefore, the placement area of all the magnetoelectric conversion elements becomes large, and as a result, a wiring substrate grows in size.

On the other hand, in a case of the arrangement of the magnetoelectric conversion elements 25a to 25j according to the present embodiment, the 5 magnetoelectric conversion elements 25a to 25e are placed on the long side L1x of the rectangle Lx, and the 5 magnetoelectric conversion elements 25f to 25j are placed on the long side L2x of the rectangle Lx.

Therefore, it is possible to reduce a distance in a short side L3x direction (X direction) necessary to arrange the magnetoelectric conversion elements 25a to 25e and the magnetoelectric conversion elements 25f to 25j. In other words, it is possible to reduce distances between the current path CB to be measured and the adjacent current paths CN.

As a result, compared with the placement area of the magnetoelectric conversion elements according to the above-mentioned comparative example, it is possible to reduce the placement area of the magnetoelectric conversion elements 25a to 25j in a direction (an extending direction of the second imaginary line IL2) orthogonal in particular to the formation direction of the cutout 17, and it is possible to achieve miniaturization of the wiring substrate 16, in other words, miniaturization of the current sensor 201. In particular, it is possible to reduce the widths of the right and left arm portions 18 of the cutout 17.

In addition, each of the magnetoelectric conversion elements 25b, 25c, and 25d on the long side L1x of the rectangle Lx is placed within a range of an angle of 45° from the X2 direction of the second imaginary line IL2x in a clockwise or counterclockwise direction about the center PP.

In addition, each of the magnetoelectric conversion elements 25g, 25h, and 25j on the long side L2x is placed within a range of an angle of 45° from the X1 direction of the second imaginary line IL2x in a clockwise or counterclockwise direction about the center PP.

In this way, element spacings between the magnetoelectric conversion elements 25a to 25j are not made equal in the long-side direction of the rectangle L, but are each concentrated within a range of an angle of 45° from the X1 or X2 direction of the second imaginary line IL2x in a clockwise or counterclockwise direction about the center PP. Accordingly, it is possible to arrange many magnetoelectric conversion elements in an area in which the magnetic field from the current path CB to be measured is strong and the Y direction component of the magnetic field is large, and it is possible to relatively reduce the influences of external magnetizing fields from the neighboring current paths CN placed at adjacent positions. Accordingly, since the influences of the external magnetizing fields on the magnetoelectric conversion elements 25a to 25j are reduced, it is possible to stably obtain detection values from the magnetoelectric conversion elements 25a to 25j.

The direction SJ of a sensitivity axis (a direction in which magnetism is sensed) of each of the magnetoelectric conversion elements 25a to 25j is parallel to the long side L1x, long side L2x, or short side L3x of the rectangle Lx and is one direction along the rectangle Lx.

Specifically, the directions SJ of the sensitivity axes of the magnetoelectric conversion elements 25a and 25f placed in corners of the rectangle L correspond to the X1 direction, and the directions SJ of the sensitivity axes of the magnetoelectric conversion elements 25e and 25j correspond to the X2 direction.

In addition, the directions SJ of the sensitivity axes of the magnetoelectric conversion elements 25b, 25c, and 25d correspond to the Y1 direction, and the directions SJ of the sensitivity axes of the magnetoelectric conversion elements 25g, 25h, and 25i correspond to the Y2 direction.

From this, the directions SJ of the sensitivity axes of the magnetoelectric conversion elements 25a to 25j are opposite to those of the magnetoelectric conversion element 25j to 25a, respectively, located at point-symmetrical positions centered on the center PP.

In an arithmetic circuit located at a subsequent stage, by adding the outputs of the magnetoelectric conversion elements 25a to 25j, components corresponding to the magnetic field of the current path CB to be measured are accumulated and validated, and components corresponding to the magnetic fields of the adjacent current paths CN are cancelled out.

Since the magnetoelectric conversion elements 25c and 25h are located on the second imaginary line IL2x, the directions SJ of the sensitivity axes thereof and the direction of the magnetic field from the current path CB to be measured nearly coincide with each other. Therefore, it is possible to detect the magnetic field with a high degree of sensitivity.

Note that in the example of Fig. 5, the direction SJ of the sensitivity axis of the magnetoelectric conversion element 25f may be set to the X2 direction opposite to that of the magnetoelectric conversion element 25a, the direction SJ of the sensitivity axis of the magnetoelectric conversion element 25j may be set to the X1 direction opposite to that of the magnetoelectric conversion element 25a, and the directions SJ of the sensitivity axes of the magnetoelectric conversion elements 25g, 25h, and 25i may be set to the Y1 direction equal to those of the magnetoelectric conversion elements 25b, 25c, and 25d.

In this case, in the arithmetic circuit located at a subsequent stage, by subtracting the outputs of the magnetoelectric conversion elements 25f to 25j from the outputs of the magnetoelectric conversion elements 25a to 25e, components corresponding to the magnetic field of the current path CB to be measured are accumulated and validated, and components corresponding to the magnetic fields of the adjacent current paths CN are cancelled out.

By using the current sensor 201 of the present magnetoelectric conversion elements, it is possible to obtain the same effect as that of the current sensor 101 of the first magnetoelectric conversion elements.

### <Third Embodiment>

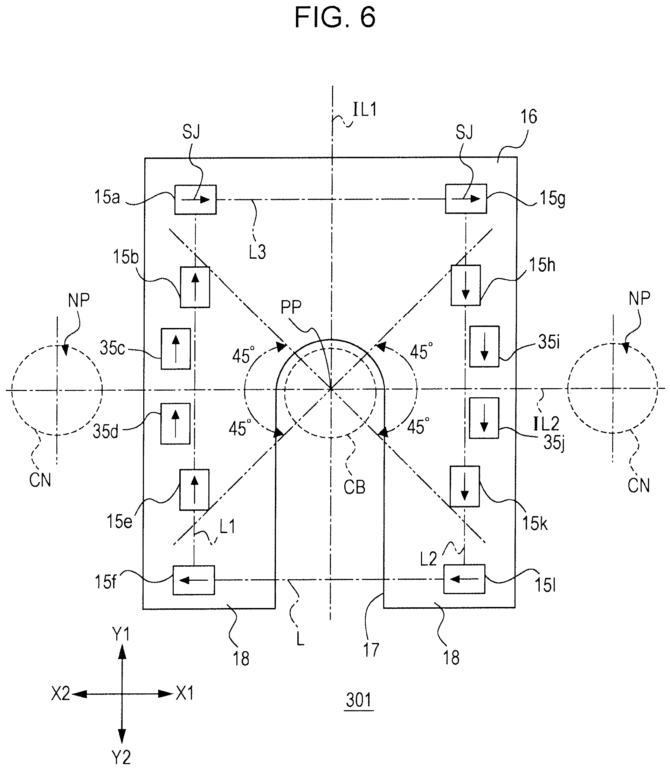

Fig. 6 is a top view of the wiring substrate 16 of a current sensor 301 according to a third embodiment of the present invention.

In Fig. 6, a configuration element to which the same symbol as that in Fig. 3 is assigned is the same as that described in the first embodiment.

As illustrated in Fig. 6, in the current sensor 301, in the same way as in the first embodiment, the magnetoelectric conversion elements 15a, 15b, 15e, 15f, 15g, 15h, 15k, and 151 are placed on the imaginary rectangle L.

In addition, as illustrated in Fig. 6, in the current sensor 301, magnetoelectric conversion elements 35c, 35d, 35i, and 35j are placed in place of the magnetoelectric conversion elements 15c, 15d, 15i, and 15j of the current sensor 101 of the first embodiment.

Unlike the first embodiment, the magnetoelectric conversion elements 35c, 35d, 35i, and 35j are placed outside the rectangle L.

The magnetoelectric conversion elements 35c and 35d are line-symmetrical with the magnetoelectric conversion elements 35i and 35j, respectively, with respect to the imaginary line IL1.

The magnetoelectric conversion elements 35i and 35j are placed point-symmetrically with the magnetoelectric conversion elements 35d and 35c, respectively, with respect to the center PP of the rectangle L.

As a result, the magnetoelectric conversion elements 35c and 35i are line-symmetrical with the magnetoelectric conversion elements 35d and 35j, respectively, with respect to the second imaginary line IL2.

Each of the magnetoelectric conversion elements 15b, 35c, 35d, and 15e is placed within a range of an angle of 45° from the X2 direction of the second imaginary line IL2 in a clockwise or counterclockwise direction about the center PP.

In addition, each of the magnetoelectric conversion elements 15h, 35i, 35j, and 15k is placed within a range of an angle of 45° from the X1 direction of the second imaginary line IL2 in a clockwise or counterclockwise direction about the center PP.

The directions SJ of the sensitivity axes of the magnetoelectric conversion elements 35c and 35d correspond to the Y1 direction, and the directions SJ of the sensitivity axes of the magnetoelectric conversion elements 35i and 35j correspond to the Y2 direction.

In an arithmetic circuit located at a subsequent stage, by adding the outputs of the magnetoelectric conversion elements 15a, 15b, 35c, 35d, 15e, 15f, 15g, 15h, 35i, 35j, 15k, and 151, components corresponding to the magnetic field of the current path CB to be measured are accumulated and validated, and components corresponding to the magnetic fields of the adjacent current paths CN are cancelled out.

Note that in the example of Fig. 6, the direction SJ of the sensitivity axis of the magnetoelectric conversion element 15g may be set to the X2 direction opposite to that of the magnetoelectric conversion element 15a, the direction SJ of the sensitivity axis of the magnetoelectric conversion element 151 may be set to the X1 direction opposite to that of the magnetoelectric conversion element 15f, and the directions SJ of the sensitivity axes of the magnetoelectric conversion elements 15h, 35i, 35j, and 15k may be set to the Y1 direction equal to those of the magnetoelectric conversion elements 15b, 35c, 35d, and 15e.

In this case, in the arithmetic circuit located at a subsequent stage, by subtracting the outputs of the magnetoelectric conversion elements 15g, 15h, 35i, 35j, 15k, and 151 from the outputs of the magnetoelectric conversion elements 15a, 15b, 35c, 35d, 15e, and 15f, components corresponding to the magnetic field of the current path CB to be measured are accumulated and validated, and components corresponding to the magnetic fields of the adjacent current paths CN are cancelled out.

In the current sensor 301, the magnetoelectric conversion elements 35c, 35d, 35i, and 35j nearly immediately lateral to the current path CB to be measured have high sensitivities because the direction of the magnetic field and magnetism sensing directions thereof are closest to each other.

According to the current sensor 301, by placing the magnetoelectric conversion elements 35c, 35d, 35i, and 35j outside the rectangle L, it is possible to reduce the sensitivities of the magnetoelectric conversion elements having the highest sensitivity and to perform highly accurate detection with a wide dynamic range. In addition, it is possible to reduce broadening of the width of the arrangement area of the magnetoelectric conversion elements.

In addition, according to the current sensor 301, by the magnetoelectric conversion elements 35c, 35d, 35i, and 35j being placed so as to be close to the outer long sides L1 and L2 of the rectangle L, it is possible to achieve miniaturization.

In addition, according to the current sensor 301, it is possible to obtain the same effect as that of the current sensor 101 of the first embodiment.

### <Fourth Embodiment>

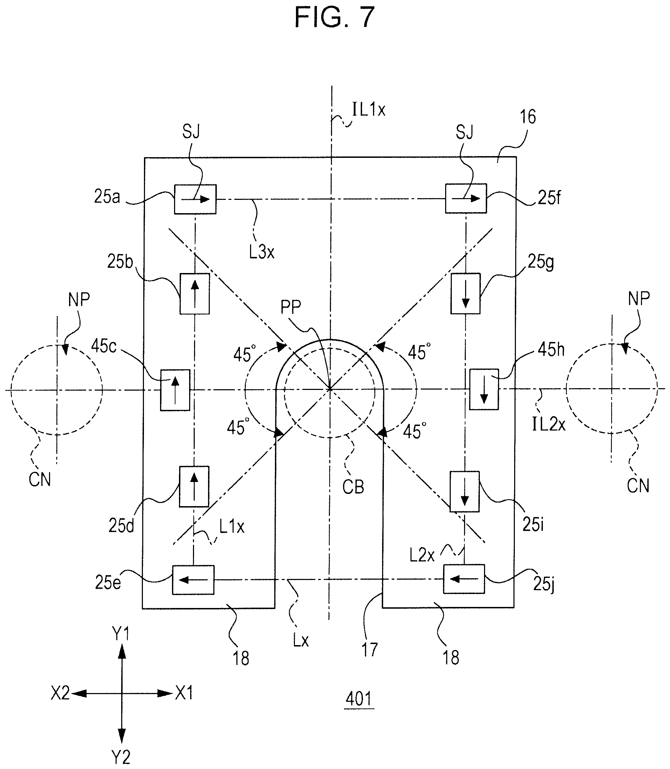

Fig. 7 is a top view of the wiring substrate 16 of a current sensor 401 according to a fourth embodiment of the present invention.

In Fig. 7, a configuration element to which the same symbol as that in Fig. 5 is assigned is the same as that described in the second embodiment.

As illustrated in Fig. 7, in the current sensor 401, in the same way as in the second embodiment, the magnetoelectric conversion elements 25a, 25b, 25d, 25e, 25f, 25g, 25i, and 25j are placed on the imaginary rectangle Lx.

In addition, as illustrated in Fig. 7, in the current sensor 401, magnetoelectric conversion elements 45c and 45h are placed in place of the magnetoelectric conversion elements 25c and 25h of the current sensor 201 of the second embodiment.

Unlike the second embodiment, the magnetoelectric conversion elements 45c and 45h are placed outside the rectangle Lx.

The magnetoelectric conversion elements 35c and 35d are line-symmetrical with the magnetoelectric conversion elements 35i and 35j with respect to the imaginary line IL1.

The magnetoelectric conversion elements 35i and 35j are placed point-symmetrically with the magnetoelectric conversion elements 35d and 35c with respect to the center PP of the rectangle L.

As a result, the magnetoelectric conversion element 45c and the magnetoelectric conversion element 45h are line-symmetrical with each other with respect to the second imaginary line IL2.

Each of the magnetoelectric conversion elements 25b, 45c, and 25d is placed within a range of an angle of 45° from the X2 direction of the second imaginary line IL2x in a clockwise or counterclockwise direction about the center PP.

In addition, each of the magnetoelectric conversion elements 25g, 45h, and 25i is placed within a range of an angle of 45° from the X1 direction of the second imaginary line IL2x in a clockwise or counterclockwise direction about the center PP.

The direction SJ of the sensitivity axis of the magnetoelectric conversion element 45c corresponds to the Y1 direction, and the direction SJ of the sensitivity axis of the magnetoelectric conversion element 45h corresponds to the Y2 direction.

In an arithmetic circuit located at a subsequent stage, by adding the outputs of the magnetoelectric conversion elements 25a, 25b, 45c, 25d, 25e, 25f, 25g, 45h, 25i, and 25j, components corresponding to the magnetic field of the current path CB to be measured are accumulated and validated, and components corresponding to the magnetic fields of the adjacent current paths CN are cancelled out.

Note that in the example of Fig. 7, the direction SJ of the sensitivity axis of the magnetoelectric conversion element 25f may be set to the X2 direction opposite to that of the magnetoelectric conversion element 25a, the direction SJ of the sensitivity axis of the magnetoelectric conversion element 25j may be set to the X1 direction opposite to that of the magnetoelectric conversion element 25e, and the directions SJ of the sensitivity axes of the magnetoelectric conversion elements 25g, 45h, and 25i may be set to the Y1 direction equal to those of the magnetoelectric conversion elements 25b, 45c, and 25d.

In this case, in the arithmetic circuit located at a subsequent stage, by subtracting the outputs of the magnetoelectric conversion elements 25f, 25g, 45h, 25i, and 25j from the outputs of the magnetoelectric conversion elements 25a, 25b, 45c, 25d, and 25e, components corresponding to the magnetic field of the current path CB to be measured are accumulated and validated, and components corresponding to the magnetic fields of the adjacent current paths CN are cancelled out.

In the current sensor 401, the magnetoelectric conversion elements 45c and 45h nearly immediately lateral to the current path CB to be measured have high sensitivities because the direction of the magnetic field and magnetism sensing directions thereof are closest to each other.

According to the current sensor 401, by placing the magnetoelectric conversion elements 45c and 45h outside the rectangle L, it is possible to reduce the sensitivities of the magnetoelectric conversion elements having the highest sensitivity and to perform highly accurate detection with a wide dynamic range. In addition, it is possible to reduce broadening of the width of the arrangement area of the magnetoelectric conversion elements.

In addition, according to the current sensor 401, by the magnetoelectric conversion elements 45c and 45h being placed so as to be close to the outer long sides L1x and L2x of the rectangle L, it is possible to achieve miniaturization.

In addition, according to the current sensor 401, it is possible to obtain the same effect as that of the current sensor 101 of the first embodiment.

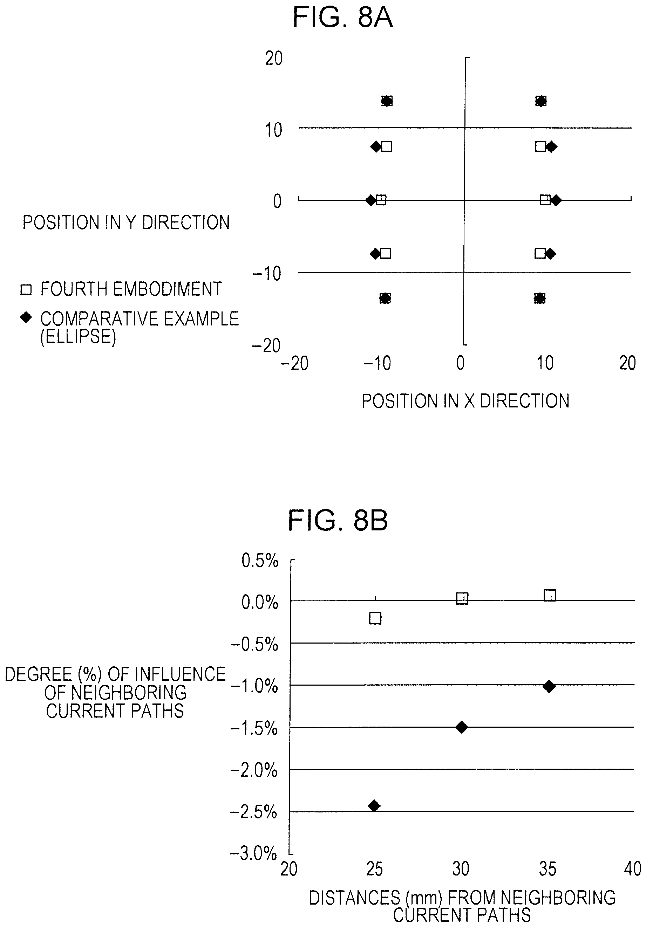

Fig. 8 is a diagram for comparing distances (mm) between the current path CB to be measured and the neighboring current paths CN and the degree (%) of influence of the neighboring current paths CN on detection values, regarding the current sensor 401 of the present embodiment and a comparative example (ellipse) in which 10 magnetoelectric conversion elements are arranged on an imaginary ellipse. Fig. 8A illustrates the arrangements of the current sensor 401 and the above-mentioned comparative example (ellipse), a horizontal axis indicates a position in the X direction, and a vertical axis indicates a position in the Y direction. In addition, in Fig. 8B, a horizontal axis indicates the distances (mm) between the current path CB to be measured and the neighboring current paths CN, and a vertical axis indicates the degree (%) of influence of the neighboring current paths CN on the detection values.

As illustrated in Fig. 8, according to the current sensor 401, compared with the above-mentioned comparative example (ellipse), it is possible to reduce the degree (%) of influence of the neighboring current paths CN, and it is possible to obtain high measurement accuracy.

The present invention is not limited to the above-mentioned embodiments.

In other words, regarding configuration elements of the above-mentioned embodiments, those skilled in the art may perform various modifications, combinations, subcombinations, and alterations insofar as they are within the technical scope of the present invention or the scope of the equivalents thereof.

In each of the above-mentioned embodiments, the number of the magnetoelectric conversion elements is not limited in particular as long as the number of the magnetoelectric conversion elements is 10 or more.

In addition, distances between the magnetoelectric conversion elements are not limited to particular distances.

In addition, while, in each of the above-mentioned embodiments, a case where magnetoelectric conversion elements having an identical characteristic are used is exemplified, magnetoelectric conversion elements having two or more characteristics may be used as long as, in an arithmetic circuit located at a subsequent stage, it is possible to accumulate and validate components corresponding to the magnetic field of the current path CB to be measured and it is possible to cancel out components corresponding to the magnetic fields of the adjacent current paths CN.

In addition, while, in each of the above-mentioned embodiments, GMR elements are preferably used as the magnetoelectric conversion elements, magnetic detecting elements capable of sensing the direction of magnetism only have to be used, and MR (Magneto Resistive) elements, AMR (Anisotropic Magneto Resistive) elements, TMR (Tunnel Magneto Resistive) elements, Hall elements, or the like may be used. In this regard, however, in a case of the Hall elements or the like, the sensitivity axes thereof are different from those of the GMR elements or the MR elements. Therefore, it is necessary to perform ingenious mounting in accordance with the sensitivity axes of the Hall elements to be used.

### Reference Signs List

101, 201, 301, 401 current sensor
11 chassis
13 connector
15, 15a to 151, 25a to 25j, 35c, 35d, 35i, 35j, 45c, 45h magnetoelectric conversion element
16 wiring substrate
L rectangle
IL1, IL1x first imaginary line
IL2, IL2x first imaginary line
L1, L1x, L2, L2x long side
L3, L3x short side
31 case

## Claims

1. A current sensor comprising:
a wiring substrate (16); and
magnetoelectric conversion elements (15) provided in the wiring substrate (16) and configured to detect magnetism generated by an electric current flowing through a current path to be measured, wherein
a cutout (17) for positioning the current path to be measured in a center of an imaginary rectangle (L) is formed in the wiring substrate (16),
4 magnetoelectric conversion elements (15a, 15f, 15g, 151) out of the magnetoelectric conversion elements (15) are provided in 4 corners of the rectangle (L),
remaining magnetoelectric conversion elements (15b, 15c, 15d, 15e, 15h, 15i, 15j, 15k) of the magnetoelectric conversion elements (15) are provided on long sides of the rectangle (L),
the magnetoelectric conversion elements (15) are provided so as to be line-symmetrical with respect to a first imaginary line (IL1) being parallel to the long sides of the rectangle (L) and passing through the center of the imaginary rectangle (L) and to be point-symmetrical with respect to the center,
each of the magnetoelectric conversion elements (15b, 15c, 15d, 15e, 15h, 15i, 15j, 15k) on the long sides is placed within a range of an angle of 45° from a second imaginary line (IL2) in a clockwise or counterclockwise direction about the center, the second imaginary line (IL2) being orthogonal to the first imaginary line (IL1) and passing through the center,
directions of sensitivity axes of the magnetoelectric conversion elements (15b, 15c, 15d, 15e, 15h, 15i, 15j, 15k) placed on the long sides are parallel to the long sides, , and
directions of sensitivity axes of the magnetoelectric conversion elements (15) located at point-symmetrical positions centered on the center are equal or opposite to each other,
**characterized in that** directions of sensitivity axes of the magnetoelectric conversion elements (15a, 15f, 15g, 151) placed on the corners are parallel to short sides.

2. The current sensor according to Claim 1, wherein
the magnetoelectric conversion elements (15b, 15c, 15d, 15e, 15h, 15i, 15j, 15k) on the long sides are placed line-symmetrically with respect to the second imaginary line (IL2) .

3. The current sensor according to Claim 1, wherein
magnetoelectric conversion elements (15) are placed at 2 positions at which the long sides and the second imaginary line (IL2) intersect with each other, and
magnetoelectric conversion elements, included in the magnetoelectric conversion elements (15b, 15c, 15d, 15e, 15h, 15i, 15j, 15k) on the long sides and different from the magnetoelectric conversion elements (15) placed at the positions at which the long sides and the second imaginary line (IL2) intersect with each other, are placed line-symmetrically with respect to the second imaginary line (IL2) .

4. A current sensor comprising:
a wiring substrate (16); and
magnetoelectric conversion elements (25) provided in the wiring substrate (16) and configured to detect magnetism generated by an electric current flowing through a current path to be measured, wherein
a cutout (17) for positioning the current path to be measured in a center of an imaginary rectangle (Lx) is formed in the wiring substrate (16),
4 magnetoelectric conversion elements (25a, 25e, 25f, 25j) out of the magnetoelectric conversion elements (25) are provided in 4 corners of the rectangle (Lx),
4 magnetoelectric conversion elements (25b, 25d, 25g, 25j) out of the magnetoelectric conversion elements (25) are provided on long sides of the rectangle (Lx),
each of the magnetoelectric conversion elements (25b, 25d, 25g, 25j) on the long sides is placed within a range of an angle of 45° from a second imaginary line (IL2x) in a clockwise or counterclockwise direction about the center, the second imaginary line being orthogonal to a first imaginary line and passing through the center, which first imaginary line is parallel to the long sides of the imaginary rectangle and passing through the center,
the magnetoelectric conversion elements (25b, 25d, 25g, 25j) on the long sides are placed line-symmetrically with respect to the second imaginary line,
directions of sensitivity axes of the magnetoelectric conversion elements (25b, 25d, 25g, 25j) placed on the long sides are parallel to the long sides,
directions of sensitivity axes of the magnetoelectric conversion elements (15) located at point-symmetrical positions centered on the center are equal or opposite to each other,
**characterized in that** 2 magnetoelectric conversion elements (45c, 45h) out of the magnetoelectric conversion elements (25) are located on the second imaginary line (IL2x) and are placed outside the rectangle (Lx),
magnetoelectric conversion elements (45c, 45d), located on the second imaginary line (IL2x) and arranged outside the rectangle (Lx), are placed line-symmetrically with respect to the first imaginary line (IL1x),
directions of sensitivity axes of the magnetoelectric conversion elements (45c, 45d) located on the second imaginary line (IL2x) and arranged outside the rectangle (L) are parallel to the long sides, and
directions of sensitivity axes of the magnetoelectric conversion elements (25a, 25e, 25f, 25j) placed on the corners are parallel to short sides.

5. A current sensor comprising:
a wiring substrate (16); and
magnetoelectric conversion elements provided in the wiring substrate (16) and configured to detect magnetism generated by an electric current flowing through a current path to be measured, wherein
a cutout (17) for positioning the current path to be measured in a center of an imaginary rectangle (L) is formed in the wiring substrate (16),
4 magnetoelectric conversion elements (15a, 15f, 15g, 151) out of the magnetoelectric conversion elements (15) are provided in 4 corners of the rectangle (L),
4 magnetoelectric conversion elements (15b, 15f, 15h, 15k) out of the magnetoelectric conversion elements (15) are provided on long sides of the rectangle (L),
each of the magnetoelectric conversion elements (15b, 15f, 15h, 15k) on the long sides is placed within a range of an angle of 45° from a second imaginary line (IL2) in a clockwise or counterclockwise direction about the center, the second imaginary line (IL2) being orthogonal to a first imaginary line (IL1) and passing through the center, which first imaginary line is parallel to the long sides of the imaginary rectangle and passing through the center,
the magnetoelectric conversion elements (15b, 15f, 15h, 15k) on the long sides are placed line-symmetrically with respect to the second imaginary line (IL2),
directions of sensitivity axes of the magnetoelectric conversion elements (15b, 15f, 15h, 15k) placed on the long sides are parallel to the long sides,
directions of sensitivity axes of the magnetoelectric conversion elements (15) located at point-symmetrical positions centered on the center are equal or opposite to each other,
**characterized in that** 4 magnetoelectric conversion elements (35c, 35d, 35i, 35j) out of the magnetoelectric conversion elements (15)are placed outside the rectangle (L),
the magnetoelectric conversion elements (35c, 35d, 35i, 35j) arranged outside the rectangle (L) are placed nearer to the second imaginary line (IL2) than the 4 magnetoelectric conversion elements (15b, 15f, 15h, 15k) on the long sides,
the magnetoelectric conversion elements (35c, 35d, 35i, 35j) placed outside the rectangle (L) are placed line-symmetrically with respect to the first imaginary line (IL1),
the magnetoelectric conversion elements (35c, 35d, 35i, 35j) placed outside the rectangle (L) are placed line-symmetrically with respect to the second imaginary line (IL2),
directions of sensitivity axes of the magnetoelectric conversion elements (35c, 35d, 35i, 35j) arranged outside the rectangle (L) are parallel to the long sides, and
directions of sensitivity axes of the magnetoelectric conversion elements (15a, 15f, 15g, 151) placed on the corners are parallel to short sides.

6. The current sensor according to any one of Claims 1 to 5, wherein
the magnetoelectric conversion elements (15) have an identical characteristic.

7. The current sensor according to any one of Claims 1 to 6, wherein
the magnetoelectric conversion elements (15) are placed so that the sensitivity axes of the magnetoelectric conversion elements (15) face in one direction along the rectangle (L).

## Patentansprüche

1. Stromsensor, aufweisend:
ein Verdrahtungssubstrat (16); und
magnetoelektrische Wandlerelemente (15), die in dem Verdrahtungssubstrat (16) vorgesehen sind und dazu ausgebildet sind, Magnetismus zu detektieren, der durch einen elektrischen Strom erzeugt wird, der durch einen zu messenden Strompfad fließt,
wobei in dem Verdrahtungssubstrat (16) ein Ausschnitt (17) zum Positionieren des zu messenden Strompfades in einem Zentrum eines imaginären Rechtecks (L) gebildet ist,
wobei vier magnetoelektrische Wandlerelemente (15a, 15f, 15g, 15l) von den magnetoelektrischen Wandlerelementen (15) an vier Ecken des Rechtecks (L) vorgesehen sind,
wobei verbleibende magnetoelektrische Wandlerelemente (15b, 15c, 15d, 15e, 15h, 15i, 15j, 15k) von den magnetoelektrischen Wandlerelementen (15) an langen Seiten des Rechtecks (L) vorgesehen sind,
wobei die magnetoelektrischen Wandlerelemente (15) derart vorgesehen sind, dass sie liniensymmetrisch in Bezug auf eine erste imaginäre Linie (IL1) sind, die parallel zu den langen Seiten des Rechtecks (L) ist und durch das Zentrum des imaginären Rechtecks (L) hindurchgeht, und in Bezug auf das Zentrum punktsymmetrisch sind,
wobei jedes der magnetoelektrischen Wandlerelemente (15b, 15c, 15d, 15e, 15h, 15i, 15j, 15k) an den langen Seiten in einem Bereich eines Winkels von 45° von einer zweiten imaginären Linie (IL2) im Uhrzeigersinn oder im Gegenuhrzeigersinn um das Zentrum angeordnet ist, wobei die zweite imaginäre Linie (IL2) orthogonal zu der ersten imaginären Linie (IL1) ist und
durch das Zentrum hindurchgeht,
wobei Richtungen von Empfindlichkeitsachsen der an den langen Seiten angeordneten magnetoelektrischen Wandlerelemente (15b, 15c, 15d, 15e, 15h, 15i, 15j, 15k) parallel zu den langen Seiten sind,
wobei Richtungen von Empfindlichkeitsachsen der magnetoelektrischen Wandlerelemente (15), die sich an punktsymmetrischen Positionen zentriert auf das Zentrum befinden, gleich oder entgegengesetzt zueinander sind,
**dadurch gekennzeichnet, dass** Richtungen von Empfindlichkeitsachsen der an den Ecken angeordneten magnetoelektrischen Wandlerelemente (15a, 15f, 15g, 15l) parallel zu kurzen Seiten sind.

2. Stromsensor nach Anspruch 1,
wobei die magnetoelektrischen Wandlerelemente (15b, 15c, 15d, 15e, 15h, 15i, 15j, 15k) an den langen Seiten liniensymmetrisch in Bezug auf die zweite imaginäre Linie (IL2) angeordnet sind.

3. Stromsensor nach Anspruch 1,
wobei magnetoelektrische Wandlerelemente (15) an zwei Positionen angeordnet sind, an denen sich die langen Seiten und die zweite imaginäre Linie (IL2) schneiden, und
wobei magnetoelektrische Wandlerelemente, die in den magnetoelektrischen Wandlerelementen (15b, 15c, 15d, 15e, 15h, 15i, 15j, 15k) an den langen Seiten enthalten sind und von magnetoelektrischen Wandlerelementen (15) verschieden sind, die an den Positionen angeordnet sind, an denen die langen Seiten und die zweite imaginäre Linie (IL2) einander schneiden, liniensymmetrisch in Bezug auf die zweite imaginäre Linie (IL2) angeordnet sind.

4. Stromsensor, aufweisend:
ein Verdrahtungssubstrat (16); und
magnetoelektrische Wandlerelemente (25), die in dem Verdrahtungssubstrat (16) vorgesehen sind und dazu ausgebildet sind, Magnetismus zu detektieren, der durch einen elektrischen Strom erzeugt wird, der durch einen zu messenden Strompfad fließt,
wobei in dem Verdrahtungssubstrat (16) ein Ausschnitt (17) zum Positionieren des zu messenden Strompfades in einem Zentrum eines imaginären Rechtecks (Lx) gebildet ist,
wobei vier magnetoelektrische Wandlerelemente (25a, 25e, 25f, 25j) von den magnetoelektrischen Wandlerelementen (25) an vier Ecken des Rechtecks (Lx) vorgesehen sind,
wobei vier magnetoelektrische Wandlerelemente (25b, 25d, 25g, 25j) von den magnetoelektrischen Wandlerelementen (25) an langen Seiten des Rechtecks (Lx) vorgesehen sind,
wobei jedes der magnetoelektrischen Wandlerelemente (25b, 25d, 25g, 25j) an den langen Seiten in einem Bereich eines Winkels von 45° von einer zweiten imaginären Linie (IL2x) im Uhrzeigersinn oder im Gegenuhrzeigersinn um das Zentrum angeordnet ist,
wobei die zweite imaginäre Linie orthogonal zu einer ersten imaginären Linie ist und durch das Zentrum hindurchgeht, wobei die erste imaginäre Linie parallel zu den langen Seiten des imaginären Rechtecks ist und durch das Zentrum hindurchgeht,
wobei die magnetoelektrischen Wandlerelemente (25b, 25d, 25g, 25j) an den langen Seiten liniensymmetrisch in Bezug auf die zweite imaginäre Linie angeordnet sind,
wobei Richtungen von Empfindlichkeitsachsen der an den langen Seiten angeordneten magnetoelektrischen Wandlerelemente (25b, 25d, 25g, 25j) parallel zu den langen Seiten sind,
wobei Richtungen von Empfindlichkeitsachsen der magnetoelektrischen Wandlerelemente (15), die sich an punktsymmetrischen Positionen zentriert auf das Zentrum befinden, gleich oder entgegengesetzt zueinander sind,
**dadurch gekennzeichnet, dass** zwei magnetoelektrische Wandlerelemente (45c, 45h) von den magnetoelektrischen Wandlerelementen (25) sich auf der zweiten imaginären Linie (IL2x) befinden und außerhalb des Rechtecks (Lx) angeordnet sind,
dass magnetoelektrische Wandlerelemente (45c, 45d), die sich auf der zweiten imaginären Linie (IL2x) befinden und außerhalb des Rechtecks (Lx) angeordnet sind, liniensymmetrisch in Bezug auf die erste imaginäre Linie (IL1x) angeordnet sind,
dass Richtungen von Empfindlichkeitsachsen der auf der zweiten imaginären Linie (IL2x) befindlichen und außerhalb des Rechtecks (L) angeordneten magnetoelektrischen Wandlerelemente (45c 45d) parallel zu den langen Seiten sind, und
dass Richtungen von Empfindlichkeitsachsen der an den Ecken angeordneten magnetoelektrischen Wandlerelemente (25a, 25e, 25f, 25j) parallel zu kurzen Seiten sind.

5. Stromsensor, aufweisend:
ein Verdrahtungssubstrat (16); und
magnetoelektrische Wandlerelemente, die in dem Verdrahtungssubstrat (16) vorgesehen sind und dazu ausgebildet sind, Magnetismus zu detektieren, der durch einen elektrischen Strom erzeugt wird, der durch einen zu messenden Strompfad fließt,
wobei in dem Verdrahtungssubstrat (16) ein Ausschnitt (17) zum Positionieren des zu messenden Strompfades in einem Zentrum eines imaginären Rechtecks (L) gebildet ist,
wobei vier magnetoelektrische Wandlerelemente (15a, 15f, 15g, 15l) von den magnetoelektrischen Wandlerelementen (15) an vier Ecken des Rechtecks (L) vorgesehen sind,
wobei vier magnetoelektrische Wandlerelemente (15b, 15f, 15h, 15k) von den magnetoelektrischen Wandlerelementen (15) an langen Seiten des Rechtecks (L) vorgesehen sind,
wobei jedes der magnetoelektrischen Wandlerelemente (15b, 15f, 15h, 15k) an den langen Seiten in einem Bereich eines Winkels von 45° von einer zweiten imaginären Linie (IL2) im Uhrzeigersinn oder im Gegenuhrzeigersinn um das Zentrum angeordnet ist,
wobei die zweite imaginäre Linie (IL2) orthogonal zu einer ersten imaginären Linie (IL1) ist und durch das Zentrum hindurchgeht, wobei die erste imaginäre Linie parallel zu den langen Seiten des imaginären Rechtecks ist und durch das Zentrum hindurchgeht,
wobei die magnetoelektrischen Wandlerelemente (15b, 15f, 15h, 15k) an den langen Seiten liniensymmetrisch in Bezug auf die zweite imaginäre Linie (IL2) angeordnet sind,
wobei Richtungen von Empfindlichkeitsachsen der an den langen Seiten angeordneten magnetoelektrischen Wandlerelemente (15b, 15f, 15h, 15k) parallel zu den langen Seiten sind,
wobei Richtungen von Empfindlichkeitsachsen der magnetoelektrischen Wandlerelemente (15), die sich an punktsymmetrischen Positionen zentriert auf das Zentrum befinden, gleich oder entgegengesetzt zueinander sind,
**dadurch gekennzeichnet, dass** vier magnetoelektrische Wandlerelemente (35c, 35d, 35i, 35j) von den magnetoelektrischen Wandlerelementen (15) außerhalb des Rechtecks (L) angeordnet sind,
dass die außerhalb des Rechtecks (L) angeordneten magnetoelektrischen Wandlerelemente (35c, 35d, 35i, 35j) näher bei der zweiten imaginären Linie (IL2) angeordnet sind als die vier magnetoelektrische Wandlerelemente (15b, 15f, 15h, 15k) an den langen Seiten,
dass die außerhalb des Rechtecks (L) angeordneten magnetoelektrischen Wandlerelemente (35c, 35d, 35i, 35j) liniensymmetrisch in Bezug auf die erste imaginäre Linie (IL1) angeordnet sind,
dass die außerhalb des Rechtecks (L) angeordneten magnetoelektrischen Wandlerelemente (35c, 35d, 35i, 35j) liniensymmetrisch in Bezug auf die zweite imaginäre Linie (IL2) angeordnet sind,
dass Richtungen von Empfindlichkeitsachsen der außerhalb des Rechtecks (L) angeordneten magnetoelektrischen Wandlerelemente (35c, 35d, 35i, 35j) parallel zu den langen Seiten sind, und
dass Richtungen von Empfindlichkeitsachsen der an den Ecken angeordneten magnetoelektrischen Wandlerelemente (15a, 15f, 15g, 15l) parallel zu kurzen Seiten sind.

6. Stromsensor nach einem der Ansprüche 1 bis 5,
wobei die magnetoelektrischen Wandlerelemente (15) eine identische Charakteristik aufweisen.

7. Stromsensor nach einem der Ansprüche 1 bis 6,
wobei die magnetoelektrischen Wandlerelemente (15) derart angeordnet sind, dass die Empfindlichkeitsachsen der magnetoelektrischen Wandlerelemente (15) entlang des Rechtecks (L) in eine Richtung weisen.

## Revendications

1. Détecteur de courant comprenant :
un substrat de câblage (16) ; et
des éléments de conversion magnétoélectrique (15) prévus dans le substrat de câblage (16) et configurés pour détecter un magnétisme généré par un courant électrique qui circule à travers un trajet du courant à mesurer ; dans lequel
une fente (17) pour le positionnement du trajet du courant à mesurer dans un centre d'un rectangle imaginaire (L) est formée dans le substrat de câblage (16) ;
quatre éléments de conversion magnétoélectrique (15a, 15f, 15g, 15l) parmi les éléments de conversion magnétoélectrique (15) sont prévus dans quatre coins du rectangle (L) ;
des éléments restants de conversion magnétoélectrique (15b, 15c, 15d, 15e, 15h, 15i, 15j, 15k) parmi les éléments de conversion magnétoélectrique (15) sont prévus sur les grands côtés du rectangle (L) ;
les éléments de conversion magnétoélectrique (15) sont prévus de façon à se retrouver en symétrie linéaire par rapport à une première ligne imaginaire (IL1) qui est parallèle aux grands côtés du rectangle (L) et qui passe par le centre du rectangle imaginaire (L) et à se retrouver en symétrie ponctuelle par rapport au centre ;
chacun des éléments de conversion magnétoélectrique (15b, 15c, 15d, 15e, 15h, 15i, 15j, 15k) sur les grands côtés est placé au sein d'une plage formant un angle de 45° par rapport à une deuxième ligne imaginaire (IL2)dans le sens des aiguilles d'une montre ou dans le sens contraire à celui des aiguilles d'une montre autour du centre, la deuxième ligne imaginaire (IL2)étant orthogonale par rapport à la première ligne imaginaire (IL1) et passant par le centre ;
les directions des axes de sensibilité des éléments de conversion magnétoélectrique (15b, 15c, 15d, 15e, 15h, 15i, 15j, 15k) placés sur les grands côtés sont parallèles aux grands côtés ; et
les directions des axes de sensibilité des éléments de conversion magnétoélectrique (15) placés à des endroits correspondant à une symétrie ponctuelle centrés sur le centre sont égales ou opposées l'une à l'autre ;
**caractérisé en ce que** les directions des axes de sensibilité des éléments de conversion magnétoélectrique (15a, 15f, 15g, 15l) placés dans les coins sont parallèles aux petits côtés.

2. Détecteur de courant selon la revendication 1, dans lequel :
les éléments de conversion magnétoélectrique (15b, 15c, 15d, 15e, 15h, 15i, 15j, 15k) sur les grands côtés sont placés en symétrie linéaire par rapport à la deuxième ligne imaginaire (IL2).

3. Détecteur de courant selon la revendication 1, dans lequel :
les éléments de conversion magnétoélectrique (15) sont placés à deux endroits auxquels les grands côtés et la deuxième ligne imaginaire (IL2) se coupent mutuellement ; et
les éléments de conversion magnétoélectrique, qui sont inclus dans les éléments de conversion magnétoélectrique (15b, 15c, 15d, 15e, 15h, 15i, 15j, 15k) sur les grands côtés et qui sont différents des éléments de conversion magnétoélectrique (15) placés à des endroits auxquels les grands côtés et la deuxième ligne imaginaire (IL2) se coupent mutuellement, sont placés en symétrie linéaire par rapport à la deuxième ligne imaginaire (IL2).

4. Détecteur de courant comprenant :
un substrat de câblage (16) ; et
des éléments de conversion magnétoélectrique (25) prévus dans le substrat de câblage (16) et configurés pour détecter un magnétisme généré par un courant électrique qui circule à travers un trajet du courant à mesurer ; dans lequel
une fente (17) pour le positionnement du trajet du courant à mesurer dans un centre d'un rectangle imaginaire (Lx) est formée dans le substrat de câblage (16) ;
quatre éléments de conversion magnétoélectrique (25a, 25e, 25f, 25j) parmi les éléments de conversion magnétoélectrique (25) sont prévus dans quatre coins du rectangle (Lx) ;
quatre éléments de conversion magnétoélectrique (25b, 25d, 25g, 25j) parmi les éléments de conversion magnétoélectrique (25) sont prévus sur les grands côtés du rectangle (Lx) ;
chacun des éléments de conversion magnétoélectrique (25b, 25d, 25g, 25j) sur les grands côtés est placé au sein d'une plage formant un angle de 45° par rapport à une deuxième ligne imaginaire (IL2x) dans le sens des aiguilles d'une montre ou dans le sens contraire à celui des aiguilles d'une montre autour du centre, la deuxième ligne imaginaire étant orthogonale par rapport à une première ligne imaginaire et passant par le centre, ladite première ligne imaginaire étant parallèle aux grands côtés du rectangle imaginaire et passant par le centre ;
les éléments de conversion magnétoélectrique (25b, 25d, 25g, 25j) sur les grands côtés sont placés en symétrie linéaire par rapport à la deuxième ligne imaginaire ;
les directions des axes de sensibilité des éléments de conversion magnétoélectrique (25b, 25d, 25g, 25j) placés sur les grands côtés sont parallèles aux grands côtés ;
les directions des axes de sensibilité des éléments de conversion magnétoélectrique (15) disposés à des endroits correspondant à une symétrie ponctuelle centrés sur le centre sont égales ou opposées l'une à l'autre ;
**caractérisé en ce que** deux éléments de conversion magnétoélectrique (45c, 45h) parmi les éléments de conversion magnétoélectrique (25) sont disposés sur la deuxième ligne imaginaire (IL2x) et sont placés à l'extérieur du rectangle (Lx) ;
les éléments de conversion magnétoélectrique (45c, 45d), disposés sur la deuxième ligne imaginaire (IL2x) et prévus à l'extérieur du rectangle (Lx), sont placés en symétrie linéaire par rapport à la première ligne imaginaire (IL1x) ;
les directions des axes de sensibilité des éléments de conversion magnétoélectrique (45c, 45d) disposés sur la deuxième ligne imaginaire (IL2x) et prévus à l'extérieur du rectangle (L) sont parallèles aux grands côtés ; et
les directions des axes de sensibilité des éléments de conversion magnétoélectrique (25a, 25e, 25f, 25j) placés dans les coins sont parallèles aux petits côtés.

5. Détecteur de courant comprenant :
un substrat de câblage (16) ; et
des éléments de conversion magnétoélectrique prévus dans le substrat de câblage (16) et configurés pour détecter un magnétisme généré par un courant électrique qui circule à travers un trajet du courant à mesurer ; dans lequel
une fente (17) pour le positionnement du trajet du courant à mesurer dans un centre d'un rectangle imaginaire (L) est formée dans le substrat de câblage (16) ;
quatre éléments de conversion magnétoélectrique (15a, 15f, 15g, 15l) parmi les éléments de conversion magnétoélectrique (15) sont prévus dans quatre coins du rectangle (L) ;
quatre éléments de conversion magnétoélectrique (15b, 15f, 15h, 15k) parmi les éléments de conversion magnétoélectrique (15) sont prévus sur les grands côtés du rectangle (L) ;
chacun des éléments de conversion magnétoélectrique (15b, 15f, 15h, 15k) sur les grands côtés est placé au sein d'une plage formant un angle de 45° par rapport à une deuxième ligne imaginaire (IL2) dans le sens des aiguilles d'une montre ou dans le sens contraire à celui des aiguilles d'une montre autour du centre, la deuxième ligne imaginaire (IL2) étant orthogonale par rapport à une première ligne imaginaire (IL1) et passant par le centre, ladite première ligne imaginaire étant parallèle aux grands côtés du rectangle imaginaire et passant par le centre ;
les éléments de conversion magnétoélectrique (15b, 15f, 15h, 15k) sur les grands côtés sont placés en symétrie linéaire par rapport à la deuxième ligne imaginaire (IL2) ;
les directions des axes de sensibilité des éléments de conversion magnétoélectrique (15b, 15f, 15h, 15k) placés sur les grands côtés sont parallèles aux grands côtés ;
les directions des axes de sensibilité des éléments de conversion magnétoélectrique (15) disposés à des endroits correspondant à une symétrie ponctuelle centrés sur le centre sont égales ou opposées l'une à l'autre ;
**caractérisé en ce que** quatre éléments de conversion magnétoélectrique (35c, 35d, 35i, 35j) parmi les éléments de conversion magnétoélectrique (15) sont placés à l'extérieur du rectangle (L) ;
les éléments de conversion magnétoélectrique (35c, 35d, 35i, 35j) prévus à l'extérieur du rectangle (L) sont disposés plus près de la deuxième ligne imaginaire (IL2) que les quatre éléments de conversion magnétoélectrique (15b, 15f, 15h, 15k) sur les grands côtés ;
les éléments de conversion magnétoélectrique (35c, 35d, 35i, 35j) prévus à l'extérieur du rectangle (L) sont placés en symétrie linéaire par rapport à la première ligne imaginaire (IL1) ;
les éléments de conversion magnétoélectrique (35c, 35d, 35i, 35j) prévus à l'extérieur du rectangle (L) sont placés en symétrie linéaire par rapport à la deuxième ligne imaginaire (IL2);
les directions des axes de sensibilité des éléments de conversion magnétoélectrique (35c, 35d, 35i, 35j) prévus à l'extérieur du rectangle (L) sont parallèles aux grands côtés ; et
les directions des axes de sensibilité des éléments de conversion magnétoélectrique (15a, 15f, 15g, 15l) placés dans les coins sont parallèles aux petits côtés.

6. Détecteur de courant selon l'une quelconque des revendications 1 à 5, dans lequel :
les éléments de conversion magnétoélectrique (15) possèdent une caractéristique identique.

7. Détecteur de courant selon l'une quelconque des revendications 1 à 6, dans lequel :
les éléments de conversion magnétoélectrique (15) sont placés d'une manière telle que les axes de sensibilité des éléments de conversion magnétoélectrique (15) sont orientés dans une seule direction qui s'étend le long du rectangle (L).
